# EUROPÄISCHE PATENTANMELDUNG

(11) **EP 2 487 495 A1**
(43) Veröffentlichungstag der Anmeldung: **15.08.2012**
(21) Anmeldenummer: 11001178.0
(22) Anmeldetag: 14.02.2011
(51) Int. Cl.: G01R 27/26

(54) **Verfahren und Vorrichtung zum Messen einer dielektrischen Antwort eines elektrischen Isoliersystems**

(71) Anmelder: Omicron electronics GmbH, 6833 Klaus (AT)
(72) Erfinder: Jaya, Michael, 76131 Karlsruhe (DE); Leibfried, Thomas, Prof. Dr.-Ing., 76646 Bruchsal (DE); Koch, Maik, Dr.-Ing., 88131 Lindau (DE); Rätzke, Stephanie, Dr.-Ing., 6850 Dornbirn (AT)
(74) Vertreter: Banzer, Hans-Jörg

(57) **Zusammenfassung**

Die vorliegende Erfindung betrifft ein Verfahren und eine Vorrichtung zum Messen einer dielektrischen Antwort eines elektrischen Isoliersystems eines elektrischen Betriebsmittels (2). Ein Spannungssignal, welches mehrere überlagerte Frequenzkomponenten umfasst, wird erzeugt (201) und an das elektrische lsoliersystem angelegt (202). Ein Stromsignal, welches durch das Spannungssignal an dem elektrischen Isoliersystem hervorgerufen wird, wird erfasst (203). Das Stromsignal kann mittels einer Verarbeitungseinheit (7) in entsprechende Frequenzanteile separiert werden.

## Beschreibung

Die vorliegende Erfindung betrifft ein Verfahren und eine Vorrichtung zur Messung einer dielektrischen Antwort eines elektrischen Isoliersystems, wobei ein Spannungssignal, welches mehrere überlagerte Frequenzkomponenten umfasst, an das elektrische Isoliersystem angelegt wird. Durch das Spannungssignal wird an dem elektrischen Isoliersystem ein Stromsignal hervorgerufen, welches erfasst wird. Das Stromsignal kann in ein entsprechendes Spannungssignal umgewandelt werden, welches auch als "äquivalentes Stromsignal" bezeichnet wird. Auf der Grundlage des Spannungssignals und des äquivalenten Stromsignals kann die dielektrische Antwort des elektrischen Isoliersystems bestimmt werden.

Elektrische Isoliersysteme werden zu lsolationszwecken bei elektrischen Betriebsmitteln, wie z. B. Leistungstransformatoren, Durchführungen oder Messwandlern, verwendet. Zur Vermeidung von Ausfällen der elektrischen Betriebsmittel wird der Zustand der elektrischen Betriebsmittel beurteilt. Die Beurteilung kann durch verschiedene Diagnoseverfahren vor Ort durchgeführt werden. Mit dem Diagnoseverfahren kann beurteilt werden, inwieweit beispielsweise ein durch elektrische, thermische oder mechanische Beanspruchung hervorgerufenes Gefährdungspotenzial besteht, um Maßnahmen zur Wartung, Instandhaltung oder Erneuerung einzuleiten. Mit Hilfe der Diagnoseverfahren sollen einerseits kritische Zustände der elektrischen Betriebsmittel frühzeitig erkannt werden und andererseits Wartungsarbeiten an den elektrischen Betriebsmitteln erst dann ausgeführt werden, wenn der Zustand dies erfordert. Durch den Einsatz der Diagnoseverfahren sollen daher einer Verlängerung der Restnutzungsdauer, eine bessere Auslastung, eine höhere Verfügbarkeit und Versorgungssicherheit, eine zustandsorientierte Wartung und Instandsetzung sowie eine Verhinderung des Ausfalls und der Zerstörung des elektrischen Betriebsmittels erreicht werden.

Ein wichtiger Aspekt der Diagnoseverfahren betrifft eine Bestimmung des Zustands des elektrischen lsoliersystems der elektrischen Betriebsmittel. Ein Verfahren zur Bestimmung des Zustands eines elektrischen Isoliersystems von beispielsweise einem Leistungstransformator ist als sogenannte PDC-Analyse (Polarisation and Depolarisation Current Analyse) bekannt. Die Analyse erfolgt im Zeitbereich und kann insbesondere den Alterungszustand der Isolierung bestimmen. Die PDC-Analyse beruht darauf, dass ein elektrisches Feld an der Isolierung durch eine Gleichspannung an den Klemmen des Transformators erzeugt wird und der dadurch verursachte Polarisationsstrom gemessen wird. Anschließend wird die Gleichspannung entfernt und der Depolarisationsstrom gemessen. Bei der PDC-Analyse werden die Polarisations- und Depolarisationsströme über eine Zeit von typischerweise 1 Sekunde bis 20 000 Sekunden aufgezeichnet und entsprechend ausgewertet. Auf der Grundlage des Polarisationsstroms und des Depolarisationsstroms und unter Berücksichtigung der Kapazität des dielektrischen Materials können eine Antwortfunktion und eine Leitfähigkeit der Isolierung bestimmt werden.

Ein weiteres Verfahren zur Messung des Zustands des Isolationssystems ist das sog. FDS-Verfahren (Frequency Domain Spectroscopy Verfahren). Bei dem FDS-Verfahren werden viele unterschiedliche Messungen bei unterschiedlichen Frequenzen durchgeführt. Beispielsweise werden Frequenzen zwischen 0,1 mHz und 100 Hz durchlaufen. Daraus werden sowohl die Kapazität als auch der Verlustfaktor des Transformators als Funktion der Frequenz ermittelt. Auf diese Weise wird mit dem FDS-Verfahren der Zustand des Isoliersystems des Leistungstransformators beurteilt.

In dem relevanten Frequenzbereich von typischerweise 0,1 mHz bis zu einigen 100 Hz liefern die zuvor genannten Verfahren in gewissen Unterbereichen jedoch sehr schlechte oder gar keine Ergebnisse oder benötigen eine sehr lange Messzeit. Beispielsweise benötigt das FDS-Verfahren im Bereich sehr tiefer Frequenzen sehr lange Messzeiten. Bei dem PDC-Verfahren ist hingegen eine Messung für Zeiten unter einer Sekunde praktisch unmöglich, da während dieser Zeit die Prüflingskapazität entladen werden muss. Ein weiterer Nachteil des PDC-Verfahrens ist die Restpolarisation des Isoliersystems. Diese Restpolarisation erhöht den Strompegel und verfälscht somit das Messergebnis. Darüber hinaus ist die Signalverarbeitung im Frequenzbereich wesentlich einfacher und genauer. Daher wird üblicherweise eine Messung im Frequenzbereich beispielsweise mit Hilfe des FDS-Verfahrens trotz der langen Messdauer bevorzugt.

Aufgabe der vorliegenden Erfindung ist es daher, ein Verfahren zur Bestimmung des Zustands eines elektrischen Isoliersystems bereitzustellen, welches genaue Messergebnisse liefert und einfach und schnell durchführbar ist.

Gemäß der vorliegenden Erfindung wird diese Aufgabe durch ein Verfahren zum Messen einer dielektrischen Antwort eines elektrischen Isoliersystems nach Anspruch 1 und eine Vorrichtung zum Messen einer dielektrischen Antwort eines elektrischen Isoliersystems nach Anspruch 10 gelöst. Die abhängigen Ansprüche definieren bevorzugte und vorteilhafte Ausführungsformen der Erfindung.

Gemäß der vorliegenden Erfindung wird ein Verfahren zum Messen einer dielektrischen Antwort eines elektrischen Isoliersystems bereitgestellt. Bei dem Verfahren wird ein Spannungssignal, welches mehrere überlagerte Frequenzkomponenten umfasst, erzeugt und an das elektrische Isoliersystem angelegt. Durch das Spannungssignal wird an dem elektrischen Isoliersystem ein Stromsignal hervorgerufen, welches erfasst wird. Auf der Grundlage des Spannungssignals und des erfassten Stromsignals kann die dielektrische Antwort des elektrischen Isoliersystems bestimmt werden.

Das Stromsignal kann in ein entsprechendes Spannungssignal umgewandelt werden, welches nachfolgend auch als "äquivalentes Stromsignal" bezeichnet werden wird. Das Stromsignal bzw. das äquivalente Stromsignal kann zur weiteren Verarbeitung mittels einer Verarbeitungseinheit in entsprechende Frequenzanteile zerlegt oder separiert werden.

Indem ein Spannungssignal mit mehreren überlagerten Frequenzkomponenten an das elektrische Isoliersystem angelegt wird, kann die dielektrische Antwort des elektrischen Isoliersystems für die mehreren überlagerten Frequenzkomponenten gleichzeitig gemessen und bestimmt werden, sodass die Messdauer erheblich verringert werden kann. Da die Messung im Frequenzbereich durchgeführt wird, können genaue Messergebnisse mit einfacher Signalverarbeitung erreicht werden.

Gemäß einer Ausführungsform werden die mehreren Frequenzkomponenten derart festgelegt, dass ein Signal-Rausch-Verhältnis des Spannungssignals oder des Stromsignals bzw. des äquivalenten Stromsignals optimiert wird. Die Festlegung der Frequenzkomponenten kann beispielsweise in Abhängigkeit von dem zu untersuchenden elektrischen Isoliersystems, z. B. eines Transformators, angepasst werden. Darüber hinaus können Spannungsvektoren, welche den Frequenzkomponenten des Spannungssignals zugeordnet sind, derart gewichtet werden, dass ein Signal-Rausch-Verhältnis des Spannungssignals oder des Stromsignals bzw. des äquivalenten Stromsignals optimiert wird.

Gemäß einer weiteren Ausführungsform wird auf der Grundlage des Spannungssignals und des Stromsignals bzw. des äquivalenten Stromsignals eine komplexe Impedanz des elektrischen Isoliersystems bestimmt. Darüber hinaus kann das Spannungssignal, welches an das elektrische Isoliersystem angelegt wird, zusätzlich erfasst werden und eine komplexe Impedanz des elektrischen Isoliersystems auf der Grundlage des erfassten Spannungssignals und des erfassten Stromsignals bestimmt werden. Dadurch kann die Genauigkeit der bestimmten komplexen Impedanz erhöht werden. Die komplexe Impedanz kann beispielsweise bestimmt werden, indem das Spannungssignal bzw. das erfasste Spannungssignal und das Stromsignal bzw. das äquivalente Stromsignal in entsprechende Frequenzkomponenten zerlegt werden. Die Zerlegung kann beispielsweise mittels einer Fourier-Transformation durchgeführt werden, um daraus die komplexe Impedanz zu bestimmen. Somit kann die komplexe Impedanz auf einfache Art und Weise mit geringem Rechenaufwand schnell bestimmt werden.

Gemäß einer weiteren Ausführungsform wird aus der komplexen Impedanz eine Kapazität des elektrischen lsoliersystems bestimmt. Darüber hinaus kann aus der komplexen Impedanz ein Verlustfaktor des elektrischen Isoliersystems bestimmt werden. Aus den so bestimmten Größen des elektrischen Isoliersystems, insbesondere der komplexen Impedanz, der Kapazität und des Verlustfaktors, kann der Zustand des elektrischen Isoliersystems eines elektrischen Betriebsmittels, beispielsweise eines Leistungstransformators, einer Durchführung oder eines Messwandlers, mit geringem Zeitaufwand genau diagnostiziert werden. Daraus können weitere Maßnahmen zur Wartung, Instandhaltung oder Erneuerung abgeleitet werden, oder frühzeitig kritische Anlagenzustände erkannt werden.

Gemäß der vorliegenden Erfindung wird weiterhin eine Vorrichtung zum Messen einer dielektrischen Antwort eines elektrischen Isoliersystems bereitgestellt. Die Vorrichtung umfasst eine Signalerzeugungseinheit, einen Spannungssignalausgang und einen Stromsignaleingang. Die Signalerzeugungseinheit ist in der Lage, ein Spannungssignal zu erzeugen, welches mehrere überlagerte Frequenzkomponenten umfasst. Das erzeugte Spannungssignal wird über den Spannungssignalausgang an das elektrische Isoliersystem ausgegeben. Über den Stromsignaleingang wird ein Stromsignal von dem elektrischen lsoliersystem erfasst, welches durch das Spannungssignal hervorgerufen wurde. Da die Signalerzeugungseinheit ein Spannungssignal mit mehreren überlagerten Frequenzkomponenten erzeugt, kann die dielektrische Antwort des elektrischen Isoliersystems gleichzeitig bei den mehreren überlagerten Frequenzkomponenten bestimmt werden. Dadurch kann die Zeit, welche zum bestimmen der dielektrischen Antwort des elektrischen Isoliersystems benötigt wird, verringert werden. Da die Messung der dielektrischen Antwort des elektrischen Isoliersystems im Frequenzbereich erfolgt, können genaue Messergebnisse mit Hilfe einer einfachen Signalverarbeitung im Frequenzbereich ermittelt werden.

Gemäß einer Ausführungsform der Vorrichtung umfasst die Vorrichtung weiterhin eine Verarbeitungseinheit, welche in der Lage ist, eine komplexe Impedanz des elektrischen Isoliersystems auf der Grundlage des Spannungssignals zu bestimmen. Auf der Grundlage der so bestimmten komplexen Impedanz können beispielsweise eine Kapazität des elektrischen Isoliersystems oder ein Verlustfaktor des elektrischen Isoliersystems bestimmt werden, sodass auf der Grundlage dieser Größen eine zuverlässige Diagnose des elektrischen lsoliersystems durchgeführt werden kann.

Gemäß einer weiteren Ausführungsform umfasst die Vorrichtung einen Spannungssignaleingang zum Erfassen des Spannungssignals, welches an das elektrische Isoliersystem angelegt wird. Darüber hinaus ist die Verarbeitungseinheit ausgestaltet, eine komplexe Impedanz des elektrischen Isoliersystems auf der Grundlage des erfassten Spannungssignals und des erfassten Stromsignals zu bestimmen. Indem die an das elektrische Isoliersystem angelegte Spannung zusätzlich über den Spannungssignaleingang gemessen wird, kann die komplexe Impedanz des elektrischen Isoliersystems sehr genau bestimmt werden, sodass eine genaue Diagnose des elektrischen Isoliersystems eines elektrischen Betriebsmittels, wie z. B. eines Leistungstransformators, einer Durchführung oder eines Messwandlers, auf dieser Grundlage durchgeführt werden kann.

Gemäß einer weiteren Ausführungsform umfasst die Signalerzeugungseinheit einen digitalen Signalprozessor. Mit Hilfe des digitalen Signalprozessors ist eine einfache und schnelle Erzeugung eines Spannungssignals mit mehreren überlagerten Frequenzkomponenten möglich.

Schließlich kann die Vorrichtung zum Durchführen des zuvor beschriebenen Verfahrens oder einer seiner Ausführungsformen ausgestaltet sein. Daher umfasst die Vorrichtung auch die zuvor beschriebenen Vorteile des zuvor beschriebenen Verfahrens und seiner Ausführungsformen.

Die vorliegende Erfindung wird nachfolgend unter Bezugnahme auf die Zeichnungen anhand bevorzugter Ausführungsformen erläutert werden.

Figur 1 zeigt ein Prinzipschaltbild einer Messanordnung mit einer Vorrichtung zum Messen einer dielektrischen Antwort eines elektrischen Isoliersystems gemäß der vorliegenden Erfindung.

Figur 2 zeigt einen prinzipiellen Ablauf eines Verfahrens zum Messen einer dielektrischen Antwort eines elektrischen Isoliersystems gemäß einer Ausführungsform der vorliegenden Erfindung.

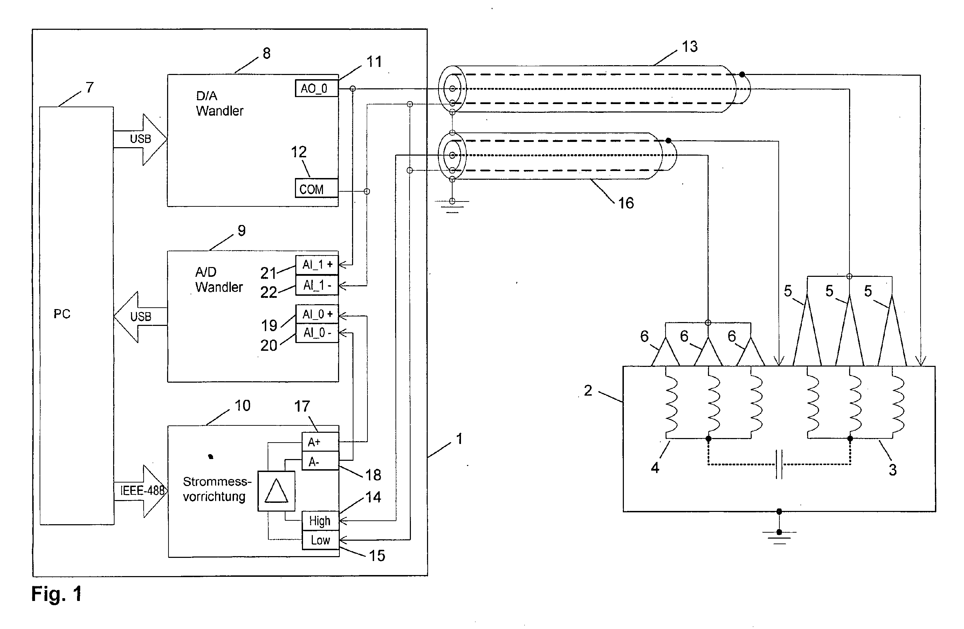

Figur 1 zeigt ein Prinzipschaltbild einer Vorrichtung 1 zum Messen einer dielektrischen Antwort eines elektrischen Isoliersystems eines elektrischen Betriebsmittels 2. In dem in Figur 1 gezeigten Beispiel ist das elektrische Betriebsmittel 2 ein Leistungstransformator. Das elektrische Betriebsmittel kann jedoch ein beliebiges anderes elektrisches Betriebsmittel sein, wie z. B. eine Durchführung oder ein Messwandler.

Der Leistungstransformator 2 umfasst eine dreiphasige Oberspannungsseite 3 und eine dreiphasige Unterspannungsseite 4. Transformatorwicklungen der Oberspannungsseite 3 sind über Anschlüsse 5 außerhalb des Transformators 2 zugänglich. Transformatorwicklungen der Unterspannungsseite 4 sind über Anschlüsse 6 außerhalb des Leistungstransformators zugänglich.

Die Vorrichtung 1 umfasst eine Verarbeitungseinheit 7, einen Digital-Analogwandler 8, einen Analog-Digitalwandler 9 und eine Strommessvorrichtung 10. Der Digital-Analogwandler 8 ist beispielsweise über einen universellen seriellen Bus, einen sog. USB, mit der Verarbeitungseinheit 7 gekoppelt. Der Analog-Digitalwandler 9 ist ebenfalls beispielsweise über einen universellen seriellen Bus mit der Verarbeitungseinheit 7 gekoppelt. Die Strommessvorrichtung 10 ist beispielsweise über einen IEEE-488 Bus mit der Verarbeitungseinheit 7 gekoppelt. Die verwendeten Busse sind nur exemplarisch und es können beliebige andere Kommunikationsverbindungen oder integrierte Lösungen verwendet werden.

Die Verarbeitungseinheit 7 kann beispielsweise einen stationären oder tragbaren Personalcomputer (PC) mit einer geeigneten Software umfassen. Die Verarbeitungseinheit 7 kann auch eine beliebige andere geeignete Verarbeitungseinheit, insbesondere beispielsweise einen digitalen Signalprozessor, umfassen. Die Verarbeitungseinheit 7 wird auch als Auswerteeinheit bezeichnet.

Der Digital-Analogwandler 8 umfasst einen Spannungssignalausgang 11 (AO_0), an welchem in Abhängigkeit von einer Ansteuerung durch die Verarbeitungseinheit 7 ein Spannungssignal bezogen auf einen Masseanschluss 12 (COM) ausgegeben wird. Das von dem Digital-Analogwandler 8 erzeugte Spannungssignal wird über eine Leitung 13, beispielsweise eine Koaxialleitung, an den Leistungstransformator 2 angelegt. Dabei wird das Spannungssignal zwischen den Transformatorwicklungen der Oberspannungsseite 3 und einem Gehäuse des Leistungstransformators 2 angelegt, d.h. der Spannungssignalausgang 11 wird mit den Oberspannungsanschlüssen 5 gekoppelt und der Masseanschluss 12 wird mit dem Gehäuse des Leistungstransformators 2 gekoppelt.

Die Strommessvorrichtung 10 der Vorrichtung 1 umfasst zwei Stromsignaleingänge 14, 15 (High, Low), welche über eine Leitung 16 mit der Unterspannungsseite 4 des Leistungstransformators 2 gekoppelt sind. Der Stromsignaleingang 14 (High) ist dabei über die Anschlüsse 6 des Leistungstransformators 2 mit den Transformatorwicklungen der Unterspannungsseite 4 gekoppelt und der Stromsignaleingang 15 (Low) ist mit dem Gehäuse des Leistungstransformators 2 gekoppelt. Die Strommessvorrichtung 10 wandelt ein an den Stromsignaleingängen 14, 15 erfasstes Stromsignal in ein entsprechendes Spannungssignal um, welches nachfolgend als äquivalentes Stromsignal bezeichnet werden wird. Das äquivalente Stromsignal wird von der Strommessvorrichtung 10 über Ausgänge 17, 18 (A+, A-) an entsprechende Messeingänge 19, 20 (Al_0+, Al_0-) des Analogdigitalwandlers 9 ausgegeben. Der Digital-Analogwandler 9 wandelt das äquivalente Stromsignal in einen entsprechenden digitalen Wert um, welcher der Verarbeitungseinheit 7 bereitgestellt wird. Der Analog-Digitalwandler 9 umfasst weiterhin zwei Messeingänge 21, 22 (Al_1+, Al_1-), welche mit den Ausgängen 11, 12 des Digital-Analogwandlers 8 gekoppelt sind, um das von dem Digital-Analogwandler 8 ausgegebene Spannungssignal in einen entsprechenden digitalen Wert umzuwandeln und der Verarbeitungseinheit 7 bereitzustellen.

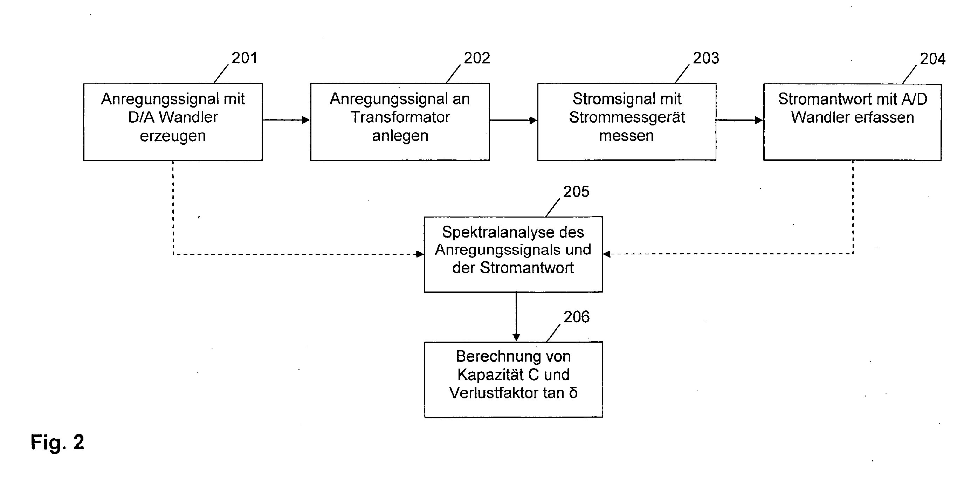

Die Arbeitsweise der in Figur 1 dargestellten Messanordnung wird nachfolgend unter Bezugnahme auf Figur 2 beschrieben werden.

Im Schritt 201 wird der Digital-Analogwandler 8 von der Verarbeitungseinheit 7 derart angesteuert, dass der Digital-Analogwandler 8 ein Spannungssignal ausgibt, welches mehrere überlagerte Frequenzkomponenten umfasst. Die einzelnen Spannungsvektoren des Spannungssignals werden gewichtet, um ein bestmögliches Signal-Rausch-Verhältnis zu erzielen. Im Schritt 202 wird das von dem Digital-Analogwandler 8 erzeugte Spannungssignal an den Leistungstransformator 2 angelegt. Durch das an den Leistungstransformator 2 angelegte Spannungssignal wird ein Strom durch das Isoliersystem des Leistungstransformators 2 verursacht, und dieser Strom wird im Schritt 203 mit Hilfe der Strommessvorrichtung 10 gemessen. Über den Analog-Digitalwandler 9 wird im Schritt 204 das so gemessene Stromsignal als Stromantwort der Verarbeitungseinheit 7 bereitgestellt. Darüber hinaus wird der Verarbeitungseinheit 7 über den Analog-Digitalwandler 9 ein Messwert des an den Transformator 2 ausgegebenen Spannungssignals bereitgestellt. Im Schritt 205 führt die Verarbeitungseinheit 7 eine Spektralanalyse von sowohl dem Stromsignal als auch dem Spannungssignal (Anregungssignal) durch. Bei der Spektralanalyse können beispielsweise mittels mathematischer Algorithmen, wie z. B. einer Fourier-Transformation, die Spannungs- und Stromsignale in ihre einzelnen Frequenzanteile zerlegt werden. Aus den einzelnen Frequenzanteilen bestimmt die Verarbeitungseinheit 7 dann die komplexe Impedanz des Isoliersystems des Leistungstransformators 2. Im Schritt 206 bestimmt die Verarbeitungseinheit 7 aus der komplexen Impedanz eine Kapazität C und einen Verlustfaktor δ für das Isoliersystem des Leistungstransformators 2.

Da das Spannungssignal mehrere überlagerte Frequenzanteile umfasst, wird die Messdauer zum Messen der dielektrischen Antwort des elektrischen lsoliersystems nur durch die tiefste vorkommende Frequenz bestimmt. Dadurch kann der Zeitaufwand gegenüber einem herkömmlichen FDS-Messverfahren deutlich verringert werden, ohne dass die Genauigkeit der Messung herabgesetzt wird.

### BEZUGSZEICHENLISTE

- 1: Vorrichtung
- 2: Elektrisches Betriebsmittel, Transformator
- 3: Oberspannungsseite
- 4: Unterspannungsseite
- 5, 6: Anschluss
- 7: Verarbeitungseinheit
- 8: Digital-Analogwandler
- 9: Analog-Digitalwandler
- 10: Strommessvorrichtung
- 11, 12: Spannungssignalausgang
- 13: Leitung
- 14, 15: Stromsignaleingang
- 16: Leitung
- 17, 18: Ausgang
- 19,20: Eingang
- 21,22: Spannungssignaleingang
- 201 ― 206: Schritt

## Patentansprüche

1. Verfahren zum Messen einer dielektrischen Antwort eines elektrischen Isoliersystems, wobei das Verfahren umfasst:
- Erzeugen (201) eines Spannungssignals, welches mehrere überlagerte Frequenzkomponenten umfasst,
- Anlegen (202) des Spannungssignals an das elektrische Isoliersystem, und
- Erfassen (203) eines Stromsignals, welches durch das Spannungssignal an dem elektrischen Isoliersystem hervorgerufen wird.

2. Verfahren nach Anspruch 1, umfassend ein Festlegen der mehreren Frequenzkomponenten derart, dass ein Signal-Rausch-Verhältnis des Spannungssignals und/oder des Stromsignals optimiert wird.

3. Verfahren nach Anspruch 1 oder 2, umfassend ein Gewichten von den Frequenzkomponenten des Spannungssignals zugeordneten Spannungsvektoren derart, dass ein Signal-Rausch-Verhältnis des Spannungssignals und/oder des Stromsignals optimiert wird.

4. Verfahren nach einem der vorhergehenden Ansprüche, ferner umfassend ein Bestimmen einer komplexen Impedanz des elektrischen lsoliersystems auf der Grundlage des Spannungssignals und des Stromsignals.

5. Verfahren nach einem der Ansprüche 1-3, ferner umfassend:
- Erfassen des an das elektrische Isoliersystem angelegten Spannungssignals, und
- Bestimmen einer komplexen Impedanz des elektrischen Isoliersystems auf der Grundlage des erfassten Spannungssignals und des Stromsignals.

6. Verfahren nach Anspruch 4 oder 5, wobei der Schritt des Bestimmens der komplexen Impedanz ferner ein Zerlegen des Spannungssignals oder des erfassten Spannungssignals und des Stromsignals in entsprechende Frequenzkomponenten umfasst.

7. Verfahren nach Anspruch 6, wobei das Spannungssignal oder das erfasste Spannungssignal und das Stromsignal mittels einer Fourier-Transformation zerlegt werden, um daraus die komplexe Impedanz zu bestimmen.

8. Verfahren nach einem der Ansprüche 4-7, ferner umfassend ein Bestimmen einer Kapazität des elektrischen Isoliersystems aus der komplexen Impedanz.

9. Verfahren nach einem der Ansprüche 4-8, ferner umfassend ein Bestimmen eines Verlustfaktors des elektrischen Isoliersystems aus der komplexen Impedanz.

10. Vorrichtung zum Messen einer dielektrischen Antwort eines elektrischen Isoliersystems, wobei die Vorrichtung umfasst:
- eine Signalerzeugungseinheit (7, 8), welche ausgestaltet ist, ein Spannungssignal zu erzeugen, welches mehrere überlagerte Frequenzkomponenten umfasst,
- einen Spannungssignalausgang (11) zum Ausgeben des Spannungssignals an das elektrische Isoliersystem, und
- einen Stromsignaleingang (14, 15) zum Erfassen eines durch das Spannungssignal hervorgerufenen Stromsignals von dem elektrischen Isoliersystem.

11. Vorrichtung nach Anspruch 10, ferner umfassend eine Verarbeitungseinheit (7), welche ausgestaltet ist, eine komplexe Impedanz des elektrischen Isoliersystems auf der Grundlage des Spannungssignals und des Stromsignals zu bestimmen.

12. Vorrichtung nach Anspruch 10, ferner umfassend:
- einen Spannungssignaleingang (21, 22) zum Erfassen des an das elektrische Isoliersystem angelegten Spannungssignals, und
- eine Verarbeitungseinheit (7), welche ausgestaltet ist, eine komplexe Impedanz des elektrischen Isoliersystems auf der Grundlage des erfassten Spannungssignals und des Stromsignals zu bestimmen.

13. Vorrichtung nach einem der Ansprüche 10-12, wobei die Signalerzeugungseinheit (7, 8) einen digitalen Signalprozessor umfasst.

14. Vorrichtung nach einem der Ansprüche 10-13, **dadurch gekennzeichnet, dass** die Vorrichtung (1) zum Durchführen des Verfahrens nach einem der Ansprüche 1-9 ausgestaltet ist.
